# EUROPEAN PATENT APPLICATION

(11) **EP 0 743 599 A2**
(43) Date of publication of application: **20.11.1996**
(21) Application number: 96870043.5
(22) Date of filing: 01.04.1996
(51) Int. Cl.: G06F 9/45

(54) **Method of generating code for programmable processor, code generator and application thereof**

(30) Priority: 15.05.1995 US 441332; 08.03.1996 EP 96870030
(71) Applicant: INTERUNIVERSITAIR MICRO-ELEKTRONICA CENTRUM VZW, B-3001 Heverlee (BE)
(72) Inventor: van Praet, Johan Roland, 1780 Wemmel (BE); Lanneer, Dirk, 3404 Landen (BE); Geurts, Werner Gustaaf Theresia, 2310 Rijkevorsel (BE); Goossens, Gert Lodewijk Huibrecht, 3001 Leuven (BE)
(74) Representative: Van Malderen, Joelle

(57) **Abstract**

The present invention concerns a method of generating code for a programmable processor comprising the steps of:
- representing said processor as a directed bipartite graph with first and second sets of vertices and with edges, said graph comprising essentially all information about the instruction set and the hardware of said processor, said first set of vertices representing storage elements in said processor, and said second set of vertices representing operations in said processor,
- linking said graph to tools and libraries required for generating code for said processor, and
- executing the required code generation phases whereby the required information about said processor is extracted from said graph.

The present invention also concerns the application of this method.

## Description

### Field of Invention

The present invention relates to computer compilers. More particularly, the invention relates to a compiler that incorporates a code generator to generate code for programmable processors and wherein a graph based representation of said programmable processors is included.

### Background of the Invention

Designers of electronic systems, as for example, consumer electronics, communication systems and multimedia related electronic systems, more and more incorporate a programmable processor in said systems. Programmability offers the possibility of a cost-effective hardware reuse and the flexibility to support last minute specification changes or to add new features to said systems.

A code generator and an instruction set simulator are the key tools to aid the designer in designing the programmable processors of said systems and in developing the software to program said processors. The effort to develop said tools should be as small as possible. Ideally, these tools should be reusable for every new programmable processor without modification. Therefore, they should be retargetable. A retargetable code generator has the extra advantage that late instruction-set changes are supported. It also aids in the design of the programmable processors by providing quality measures (code size, execution time, resource utilization, and the like) on the mapping of applications to different hardware variations.

Code generators have different specific tasks to fulfill of which the most important ones are code selection, register allocation and scheduling. Each of these tasks is implemented in a different program called a code generator phase which works on a different view of the processor. Processor models for existing code generators are just a set of these different views.

It is to be noted that the requirements of programmability, low cost and low power have resulted in a new class of application specific instruction set processors (ASIPs). These are a hybrid form of custom architectures and standard processors, offering an instruction set and hardware implementation which are optimized for a small number of applications. Because of the small number of applications to be mapped on an ASIP, it is of importance to have retargetable code generators for this class of programmable processors.

In the following paragraphs prior art processor models and descriptions that are used in code generation and in retargetable code generation for different types of processors are reviewed.

The first retargetable code generators were designed for complex instruction set computers (CISCs). The architecture of these computers contains instructions with complicated operation patterns. Code selection was the most important task in these code generators and it performed register allocation and scheduling as a by-product. Code selection was implemented as tree pattern matching. As a consequence, the processor descriptions were tree or string grammars in which the production rules directly model the operation patterns available in the instruction set (Glanville and Graham, "A new method for compiler code generation", Proc. 5th Ann. ACM SYMP. on Princ. of Prog. Lang., pages 231-240, 1978; Aho and Tjiang, "Code-generation using tree matching and dynamic programming", ACM Trans. on Prog. Languages and Systems, Vol. 11, No. 4, pages 491-516, 1989). Some descriptions were more complicated and contained matching preconditions related to hardware peculiarities, data types, storage locations and addressing modes.

In other approaches, a machine description is an enumeration of all instructions along with their corresponding simple register transfers. Also, the application is transformed in these register transfers. Code selection is performed by combining register transfers in the application into groups to be performed by one instruction (Davidson and Fraser, "The design and application of a retargetable peephole optimizer", ACM Trans. on Prog. Languages and Systems, Vol. 2, No. 2, pages 191-202, 1980).

More recent code generators have been developed for reduced instruction set computers (RISCs). In this case, the register allocation and scheduling tasks are more important than code selection and also need their specific information. For example, the processor description of the Marion retargetable code generator for RISCs (Bradlee, "Retargetable instruction scheduling for pipelined processors", Ph.D thesis at the University of Washington, 1991) contains a declaration of storage elements and other resources in addition to the instruction set enumeration. The register transfers are then annotated with scheduling and resource utilization information.

Recent retargetable code generators for ASIPs (Paulin, et al., "DSP tool requirements for embedded systems: a telecommunications industrial perspective", J. VLSI Signal Processing, Vol. 9, No. 1, 1995; Fauth and Knoll, "Automated generation of DSP program development tools using a machine description formalism", Proc. IEEE of ICASSP 93, Minneapolis, 1993) also use different views of a processor.

Retargeting the above mentioned code generators to a new processor involves rewriting all the code generator phase specific views of the processor. This is a large effort especially because all views must be kept consistent. To solve this problem, some (e.g. Fauth and Knoll) try to derive the models from one processor description language (nML). This approach needs an analysis program for each model which is still a lot of work to implement.

In code generators of prior art, the code generator phases use different models each containing a different view of the processor. This makes it difficult to have them work closely together.

A. Fauth, et al. furthermore teach in "Describing instruction set processors using nML", Proc. European Design Test Conference, Paris, France, 1995, the use of the nML formalism to describe processors in terms of their instruction set. Situated at the level of description that is found in programmer's manuals, nML allows for concise specifications of programmable instruction set processors.

Some retargetable code generators already introduced a graph processor model. These graph models however do not contain sufficient information for all phases in a code generator. Mueller (Mueller and Varghese, "Flow graph machine models in microcode synthesis", Proc. 6th Ann. Workshop on Microprog., pages 159-167, 1983) used a graph model for performing the task of code selection by symbolic execution. For the processors he targeted, a by-product of this code selection was register allocation. Scheduling was performed separately using a different view of the processor. Nowak (Nowak and Marwedel, "Verification of hardware descriptions by retargetable code generation", 26th ACM/IEEE Design Automation Conference, 1989) extracts a so-called connection-operation graph from a structural processor description. The description is a detailed netlist of the processor including the controller and the instruction decoder, but this is often not available to the software developer. The connection-operation graph maps all conflicts on the instruction word and does not support additional checks for hardware conflicts. As a consequence, bus conflicts must be treated separately. The model only supports single-cycle operations.

J.Van Praet, et al. discloses in "Instruction set definition and instruction selection for ASIPs", presented at the Int. Symposium on High Level Synthesis, Ontario, Canada, May 18-20, 1994, Proc. IEEE of 1994 how instruction selection for ASIPs can be done by generating a combined instruction set and data-path model from the instruction set and an abstract data-path description, and by performing operation bundling on that model. The same disadvantages as identified for the graph models of Nowak and Mueller apply for this method.

### Summary of the Invention

One aspect of the present invention is to disclose a method for generating code on a programmable processor using a graph based instruction set processor representation which models a processor with essentially all peculiarities of the architecture and the instruction set. The model, a directed bipartite graph, can be used in all code generator phases and thus eliminates the need for different phase specific machine descriptions such as, for example, an exhaustive enumeration of operation patterns for code selection or a listing of register classes for register allocation. All code generation phases find the information they need in the model without any analysis. The model can also be used in an instruction set simulator. This method based on a directed bipartite graph model is not only applicable to ASIPs but also to general purpose processors.

Phases in a code generator cooperate better when working on one global and complete model of the processor because of better consistency, verifiability and efficiency.

A processor model for retargetable code generation and instruction simulation must contain all information about the processor needed to generate correct efficient code and to simulate the content of every storage element during program execution in an instruction cycle accurate way. It must allow code generation phases to find out what operations and storage elements are available in the instruction set and how they are interconnected. Code generation and simulation programs must also contain information about all possible conflicts in a processor such as encoding restrictions and hardware conflicts. In short, the model must support efficient searches for valid patterns that translate into valid register transfers on the processor (which are enabled by a partial instruction). Also the timing and behavior of operations must be easily accessible.

The processor model should not, however, contain unnecessary details nor predicates to guide the code generator phases or the simulator. Not needed are, for example, the details of the decoding tables, precise timing on the sub-phases of the clock and exact modelling of hardware of which the behavior does not introduce any conflicts.

If the required information for executing the code generation phases and for simulating the execution of code is contained in the processor model, retargeting the code generator or simulator consists of providing the generator or the simulator with a new processor model. If the model is sufficiently abstract (i.e., it does not contain phase-specific information), this is a relatively small effort.

The processor model, a directed bipartite graph, advantageously can also be used in a method for synthesizing hardware that implements the processor described by said model. Said method for synthesizing the hardware comprises the step of deriving from said instruction set graph a netlist containing hardware building blocks and implementing said processor as a hardware device according to said netlist.

According to another aspect of the present invention, a method of generating code for a programmable processor is disclosed. Said method comprising the steps of:
- representing said processor as a directed bipartite graph with first and second sets of vertices and with edges, said graph comprising essentially all information about the instruction set and the hardware of the processor, said first set of vertices representing storage elements in said processor, and said second set of vertices representing operations in said processor,
- linking said graph to tools and libraries required for generating code for said processor, and
- executing the required code generation phases whereby the required information about said processor is extracted from said graph.

An operation is defined as a primitive processor activity. The operations are annotated with their enabling conditions representing the values of the instruction word that activate them.

In this method, said edges represent valid connections between said operations and said storage elements, said connections modelling the data flow in said processor.

According to one preferred embodiment of the present invention, this method can be adapted for evaluating the optimization phase of generating code for an application algorithm and therefore it further comprises the step of building a decision tree with vertices and branches wherein:
- vertices of said decision tree represent primitive operations, whereby said application algorithm contains instances of said primitive operations;
- said branches represent possible transformations of said primitive operations according to alternative mapping possibilities in said optimization space, and
- wherein, the set of vertices of said decision tree comprises vertices representing patterns of other vertices of said set, said pattens being defined during said code generation phases, and said second set of vertices representing operations of said processor.

According to another preferred embodiment, this method can furthermore comprise the steps of:
- representing hardware conflicts in said processor as access conflicts on said vertices representing said storage elements; and
- annotating each vertex of said second set of vertices representing operations with their enabling condition, said enabling condition representing values in the instruction register of said processor that enable the execution of the operation represented by said vertex.

If said method determines valid partial instructions, it further comprises the steps of:
- selecting a subset of said second set of vertices representing operations;
- verifying that the intersection of the enabling conditions of all operations of said subset is not empty; and
- verifying that said subset is free of access conflicts on said storage elements.

By checking the enabling conditions and hardware conflicts, the code generator can search for valid operation patterns in the instruction set graph. Valid operation patterns are patterns without conflicts.

Said storage elements can be static and transitory elements. In this case, the method according to the present invention further comprises the steps of representing all hardware conflicts in said processor as access conflicts on said vertices representing said transitory storage elements.

The method can also be adapted to specify data-types supported by a storage element, said method further comprising the steps of:
- specifying different vertices representing one storage element;
- annotating each of said different vertices with a data type supported by said one storage element, and
- specifying an alias relationship between said different vertices representing said one storage element.

The method can also be adapted for representing record storage elements, said method further comprising the steps of:
- specifying a vertex representing the concatenation of several storage elements;
- annotating said vertex with a data type being a record of the data types of said storage elements;
- specifying a structural relationship between said vertex and the vertices representing said storage elements.

The method as defined is adapted for representing operations of which the execution depends on a defined condition, said method further comprising the steps of:
- specifying a subset of said second set of vertices representing operations, characterized in that all vertices in said subset depend on said condition;
- specifying in said subset a vertex that is connected by an incoming edge to a vertex of said first set of vertices that represents the storage element where said condition is available;
- specifying that said operations represented in said subset can only be enabled when said condition has a specific value.

The execution times of operation are modelled, said method further comprising the steps of :
- annotating an enabling condition of said operation with the relative time step of the corresponding instruction issue with respect to the start of said operation; and
- annotating said operation with the time steps relative to the start of said operation at which said operation accesses the input and output storage elements of said operation.

If the method represents a functional unit in said processor, it further comprises the steps of specifying a subset of said second set of vertices representing operations, all vertices in said subset executing one functional unit.

Said processor includes a controller unit, operations modelling said controller unit are represented as vertices of said second set of vertices representing operations.

The present invention furthermore discloses a retargetable code generator as an executable computer program on a computer for generating code for programmable processors comprising:
- tools to build a directed bipartite graph with vertices and edges which internally represents said programmable processor, said graph comprising essentially all information about the instruction set and the hardware of said processor having first and second set of vertices, said first set of vertices representing storage elements in said processor, and said second set of vertices representing operations in said processor.
- tools and libraries required to generate code for said processor, and
- means to link said graph to said tools and said libraries, whereby the information about said processor requested during code generation is extracted from said graph.

The present invention furthermore discloses a method of constructing a code generator for a programmable processor comprising the steps of:
- representing said processor as a directed bipartite graph with first and second sets of vertices and with edges, said graph comprising essentially all information about the instruction set and the hardware of the processor, said first set of vertices representing storage elements in said processor, and said second set of vertices representing operations in said processor,
- linking said graph to tools and libraries required for generating code for said processor, and
- executing the required code generation phases whereby the required information about said processor is extracted from said graph.

In another embodiment, this method of constructing a code generator can further comprise the steps of:
- representing hardware conflicts in said processor as access conflicts on said vertices representing said storage elements; and
- annotating each vertex of said second set of vertices representing operations with their enabling condition, said enabling condition representing values of the instruction register of said processor that enable the execution of the operation represented by said vertex.

Said method determines valid partial instructions, and further comprises the steps of:
- selecting a subset of said second set of vertices representing operations;
- verifying that the intersection of the enabling conditions of all operations of said subset is not empty; and
- verifying that said subset is free of access conflicts on said storage elements.

The present invention is also related to a method of simulating the execution of code on a programmable processor which comprises the steps of:
- representing said processor as a directed bipartite graph with first and second sets of vertices and with edges, said graph comprising essentially all information about the intruction set and the hardware of said processor, said first set of vertices representing storage elements in said processor, and said second set of vertices representing operations in said processor, said edges representing valid connections between operations and said storage elements, and said connections modelling the data flow in said processor;
- linking said graph to tools and libraries required for said simulation, and
- executing said simulation whereby the required information about said processor is extracted from said graph.

Furthermore, a retargetable simulator is disclosed as an executable computer program on a computer for simulating the execution of code on a programmable processor comprising:
- a tool to build an internal representation of a directed bipartite graph which represents said programmable processor with first and second sets of vertices and with edges, said graph comprising information about the instruction set and the hardware of said processor, said first set of vertices representing storage elements in said processor, and said second set of vertices representing operations in said processor;
- tools and libraries required for simulating said processor, and
- means to link said group of said tools and libraries whereby the information about said processor requested during simulation is extracted from said graph.

Furthermore, a method of synthesizing a programmable processor is disclosed which comprises the steps of:
- representing said processor as a directed bipartite graph with first and second set of vertices and with edges, said graph comprising information about the instruction set and the hardware of said processor;
- linking said graph to tools and libraries required for generating a netlist of hardware building blocks;
- implementing said processor as a hardware device according to said netlist.

### Brief Descriptions of the Drawings

The present invention will be described below in connection with accompanying drawings figures in which:
- **Figure 1**: shows the data path of a small example processor.
- **Figure 2**: represents a schematic overview of the instruction set for the example processor.
- **Figure 3**: illustrates the instruction set graph for the (partial) instructions using the ALU in the example processor.
- **Figure 4**: represents different ways of controlling a multicycle multiply-accumulate, modelled in the ISG: (a) non-pipelined; (b) pipelined, data-stationary controlled, and (c) pipelined, time stationary controlled.
- **Figure 5**: illustrates the type hierarchy in the operation type library L. The gray plane "P" represents the ISG.
- **Figure 6**: represents different kinds of data dependencies in the DFG: (a) direct data dependency; (b) direct data dependency with move operation; (c) allocated data dependecy.
- **Figure 7**: shows an if-then-else construct in C and its corresponding CDFG in part (a); part (b) shows a small ISG to map the C program of part (a).
- **Figure 8**: shows a conditional operation in C and its corresponding CDFG in part (a); part (b) shows a small ISG to map the C program of (a).
- **Figure 9**: illustrates the modelling of residually controlled operations in the ISG.
- **Figure 10**: represents two different ways of handling data type information in the ISG.
- **Figure 11**: depicts the hierarchy which is present in the nML description of the example processor.
- **Figure 12**: illustrates the flow diagram of a retargetable compiler.
- **Figure 13**: represents the flow diagram of a retargetable simulator generator.
- **Figure 14**: represents the flow diagram of an nML to ISG translator.
- **Figure 15**: depicts the information structure diagram of the preferred embodiment of the ISG model.

### Detailed Descriptions of Preferred Embodiments

A processor model for retargetable code generation and instruction simulation must contain all information about the processor needed to generate correct efficient code and to simulate the content of every storage element during program execution in an instruction cycle accurate way. It must allow code generation phases to find out what operations and storage elements are available in the instruction set and how they are interconnected. Code generation and simulation programs must also contain information about all possible conflicts in a processor such as encoding restrictions and hardware conflicts. In short, the model must support efficient searches for valid patterns that translate into valid register transfers on the processor (which are enabled by a partial instruction). Also the timing and behavior of operations must be easily accessible.

The processor model should not, however, contain unnecessary details nor predicates to guide the code generator phases or the simulator. Not needed are, for example, the details of the decoding tables, precise timing on the sub-phases of the clock and exact modelling of hardware of which the behavior does not introduce any conflicts.

### An example processor

A small example processor will be used to illustrate the concepts of the instruction graph model of the present invention. This processor is derived from a commercial processor for digital signal processing, namely the ADSP-2111 from Analog Devices. It should be understood, however, that the present invention is in no way restricted to this processor. The method is applicable to other commercial processors as well, and the method has already been applied to different ASIPs.

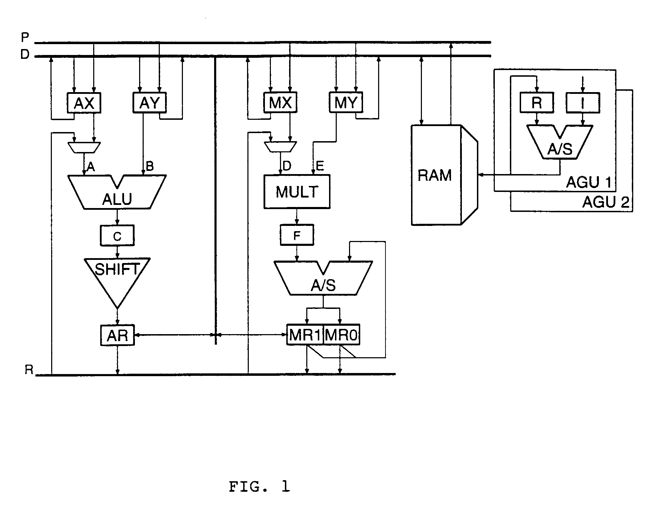

The data path (shown in figure 1) contains an ALU-SHIFT unit, consisting of an ALU connected through a pipeline register C to a shifter (SHIFT), and a multiply accumulate unit (MULT and A/S, with pipeline register F). Both units have their own input registers (AX,AY;MX,MY, respectively) and result registers (AR;MR1,MRO, respectively), and communicate with each other via the result bus R. The processor has a load/store architecture and can fetch two operands at a time by using both the program bus (P) and the data bus (D).

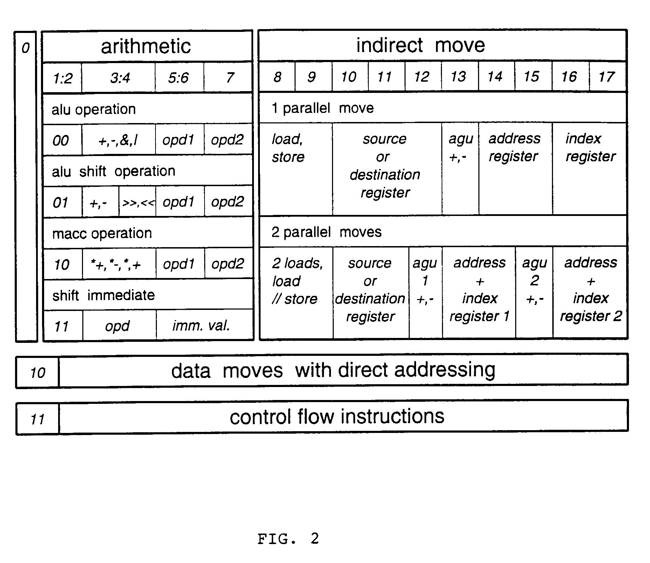

The instruction set is outlined in figure 2 and comprises three formats. The instruction word length is 18 bits (bits are numbered from 0 to 17, with 0 being the most significant bit). In the table, only format bits are shown. The first format, which deals with instructions incorporating an arithmetic operation with one or two indirectly addressed data moves in parallel, is detailed. One can see that the encoding excludes the parallel operation of the two arithmetic parts in the data path. The second format encodes data moves with direct addressing and the third one contains all control flow instructions.

### 1. A BIPARTITE GRAPH AS A PROCESSOR MODEL

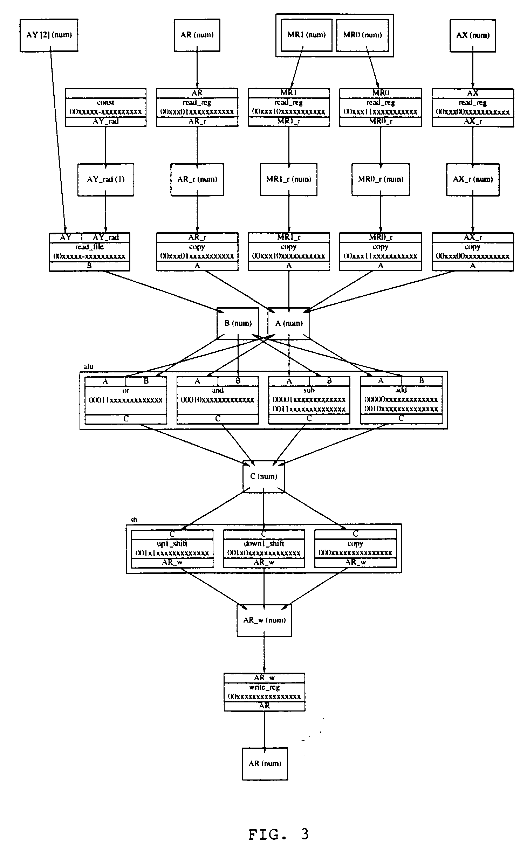

The instruction set graph (ISG) for the present invention is designed in accordance with the above requirements. It is a directed bipartite graph G_{ISG} (V_{ISG},E_{ISG}) with V_{ISG} = V_{S} ∪ V_{I}, where V_{S} contains vertices representing storage elements in the processor and V_{I} contains vertices representing its operations. The edges in V_{ISG} ⊂ (V_{S} x V_{I}) ∪ (V_{I} x V_{S}) represent the connectivity of the processor and model data flow from storage, through ISG operations, to storage. Figure 3 contains a part of the ISG for the example processor; the details of this figure will be explained below.

### ISG operations.

ISG operations are primitive processor activities transforming values in storage elements into other values in other storage elements.

In each instruction, the processor executes a number of operations. Conversely, a certain operation can be enabled by several instructions. The set of instructions that enables an operation i in the ISG is called its enabling condition and denoted by **enabling**(*i*). It is currently assumed that the binary encoding of instructions is available to be used in the enabling conditions. However, the enabling conditions could also be defined in a more abstract way, using assembler-like symbols (mnemonics) for instruction parts. In Figure 3, the enabling conditions are shown in a binary cubic representation, with "x" meaning "don't care". A subset of ISG operations V_{Io} ⊂ V_{I} is said to have an encoding conflict when ∩_{i∈VIo} **enabling**(*i*) = Φ. The intersection of enabling conditions ∩_{i∈VIo} **enabling**(*i*) is the enabling condition for the set V_{Io}, which is empty in the case of an encoding conflict. A multiplexer is for example modelled as a set of **copy** operations having a common output storage element such that all pairs of **copy** operations have encoding conflicts.

### Storage

In the ISG, a distinction is made between two kinds of storage elements. See, for example Landskov, Davidson et al., "Local microcompaction techniques", ACM computing surveys, 12(3)261-294, 1980. In particular, the two kinds of storage elements are defined as follows :
1. ***Static*** storage holds its value until explicitly overwritten. The same value can be read several times. A static storage element has a certain capacity of values it can contain at the same time (e.g. the number of fields in a register file). Static storage consists of memory and controllable registers, respectively denoted by the sets V_{M} and V_{R}.
*2.* ***Transitory*** storage passes a value from input to output with a certain delay. A transitory storage element will simply be called a transitory. A transitory can only contain one value at a time. Examples are buses and wires, which have zero delay, and pipeline registers which have a non-zero delay. Transitories form the set V_{T}.

Together, the storage elements define a ***structural skeleton*** of the target machine (V_{S} = V_{M} ∪ V_{R} ∪ V_{T}). In Figure 3, storage elements are depicted as small rectangular boxes, each having a label denoting their data type between parentheses. In the example the data type is named **num** and is an additional interpretation of a bit string of length 16. The storage elements at the top and bottom are registers, all others are transitories.

A code generator must not only check for encoding restrictions between operations, but also for *hardware conflicts* (or structural hazards), which are not always prevented by the encoding conflicts. For example, hardware conflicts can occur between operations of orthogonal instruction fields. Such instructions are called "illegal" instructions. In the case of pipelined processors, hardware conflicts can even occur between operations of different instructions and timing profiles must be taken into account. An interesting feature of transitories is that they are used to model hardware conflicts in code generation.

A hardware conflict is represented as an access conflict on a transitory. The code generator will avoid access conflicts on transitories, by allowing at most one operation to write to each transitory in each machine cycle. To illustrate the modelling of hardware conflicts, two examples will be considered :
- Different tristate drivers can be connected to the same bus and are not allowed to write to it during the same cycle, even not when an instruction encoding allows it. To prevent the code generator from generating such an instruction, the bus is modelled as a transitory and the tristate drivers as **copy** operations. The conflict then turns into an access conflict on the transitory (i.e. a bus conflict) which can be checked and avoided by the code generator. This resembles the way a multiplexer is modelled in the ISG, but in the case of a bus conflict the enabling conditions of the **copy** operations are not exclusive. Remark that in the ISG of Figure 3 the result bus has not been modelled explicitly (it is merged with the multiplexer) because no result bus conflicts occur with the example instruction set.
- Read/write ports of static storage are also modelled as transitories in order to make the code generator check for ***port conflicts****.* Port conflicts occur when two operations try to access a storage element via the same port in the same cycle.

In summary, memory and register nodes are included in the ISG as they are present in the architecture. Transitories on the other hand, are not necessarily uniquely related to physical interconnect resources in the architecture. An operation may for example encapsulate a physical interconnection, or a transitory may be needed to connect the parts of an operation that is artificially split. It is however crucial that the correct processor behaviour is represented, including the hardware conflicts.

### Timing

A multi-cycle instruction may activate operations some cycles after the instruction issue. Therefore an enabling condition is annotated with the relative time step of the instruction issue with respect to the start of the operation. The term ***operation stage*** will be used to denote a time step relative to the (execution) start of an operation. For example, operation stage 0 and 1 are respectively the first and second step in which the corresponding operation is active, and stage -1 is the last time step ***before*** the operation becomes active. Each operation is also annotated with the operation stage at which it accesses its input and output storage elements.

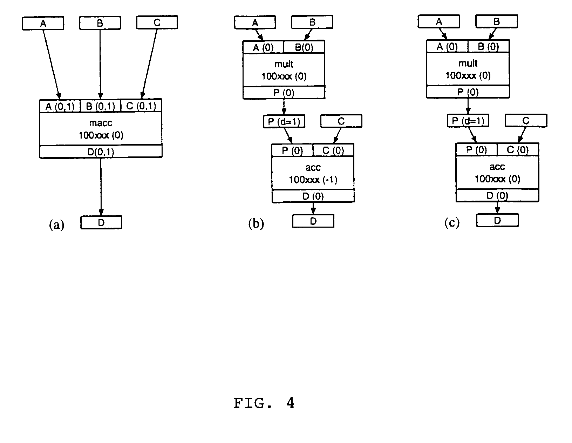

The operations and instructions in the previously discussed example processor are all single-cycle, so the operation timing is omitted in Figure 3, but it is annotated in Figure 4 for some fictitious examples. Operation stages are shown between parenthesis, as annotations of enabling conditions and of input and output arguments of ISG operations. Figure 4(a) shows how a two-cycle, non-pipelined multiply-accumulate operation would look like in the ISG, assuming that it needs its input and output storage elements during both cycles.

In data-stationary code, one instruction controls all operations that are executed on a data item as it is traversing the pipeline (P.M. Kogge, "The Architecture of Pipelined Computers", Advanced Computer Science Series, McGraw-Hill Book Company, 1981).

A data-stationary instruction that controls a two-cycle multiply-accumulate pipeline, is modelled by two ISG operations, as shown in Figure 4(b). The operations are connected by a transitory with a delay of one cycle and each of them is annotated with operation stages. The code generator can then easily derive the timing of the complete pattern and replace the pattern by a more abstract operation, as will be explained in the sequel.

If the same multiply-accumulate pipeline is time-stationary controlled, it is modelled as in Figure 4(c). In time-stationary code, one instruction controls all operations that are executed during one cycle, possibly on several sets of data (P.M. Kogge, "The Architecture of Pipelined Computers", Advanced Computer Science Series, McGraw-Hill Book Company, 1981).

To allow the code generator to also replace this operation pattern by an abstract operation, multi-cycle operations are allowed to have multiple enabling conditions, for example one for each cycle.

### 2. CODE GENERATION USING THE ISG MODEL.

In this section it will be explained how the ISG processor model is used to generate code for the execution of a given algorithm on a given processor. In the sequel an overview of a retargetable compiler, using the preferred embodiment of the present invention, is given by means of a flow diagram. The implementation of the ISG is also discussed in the sequel.

The algorithm to be mapped on the processor is given as a data flow graph (DFG) which also takes the form of a bipartite graph G_{DFG} (V_{DFG},E_{DFG}), where V_{DFG} = V_{O} ∪ V_{V} with V_{O} representing the operations and V_{V} representing the values they produce and consume. The edges in E_{DFG} ⊂ (V_{O} x V_{V}) ∪ (V_{V} x V_{O}) represent the data flow. Code generation then consists in finding a mapping of G_{DFG} (V_{DFG},E_{DFG}) onto G_{ISG} (V_{ISG},E_{ISG}) with values in V_{V} mapped on storage elements in V_{S} and the DFG operations of V₀ on corresponding ISG operations of V_{I}.

The code generation task is split in subsequent phases. First, during the code selection phase, it is decided on which values will be bound to transitories. A data dependency of which the corresponding value is bound to a transitory, results in a fixed timing constraint because of the delay of the transitory. This timing constraint may not produce a conflict between the involved DFG operations, otherwise it can not be satisfied and the value must be bound to a static storage element. Conflict free DFG operations with fixed timing constraints are grouped, and each implementation of such a group is called a ***bundle****.* After this, during the register allocation phase, the remaining values are bound to static storage elements and the DFG is completed with the necessary data transfers. Finally, during the scheduling phase, the bundles are bound to time. Below, more details are given on how the DFG is bound to the ISG.

### Refinement

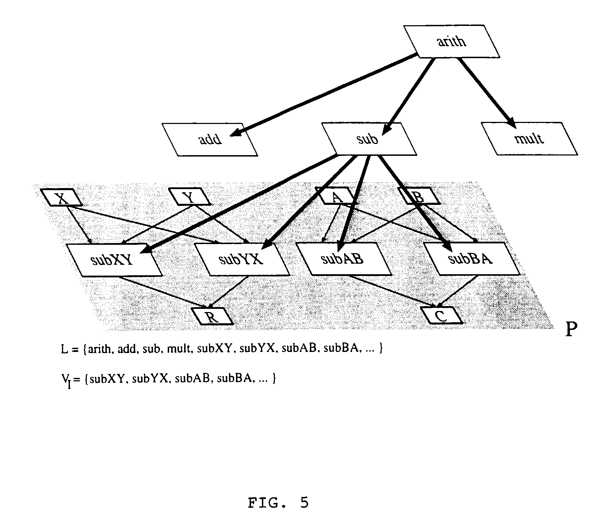

To represent the different ways in which a DFG operation can be mapped on the ISG, an operation type hierarchy is used. Figure 5 shows an example of this hierarchy for a subtraction, where four implementations exist for the abstract **sub** operation type. Each implementation is a subtype of an abstract operation type, for example, **subXY** is a subtype of **sub**. The abstract operations and the operations in the ISG form a library L of primitive operations of which DFG operations are instances. Each DFG operation is an instance of an operation type in *L :*$\text{∀o} {\text{∈ V}}_{\text{O}} \text{, ∃} \text{l} \text{∈} \text{L :} \text{type(} \text{o} \text{) =} \text{l.}$

In fact, the library *L* is a decision tree with vertices and branches which is used in the mapping of a DFG to the ISG. Vertices correspond to primitive operations, and branches represent possible refinements of primitive operations according to alternative mapping possibilities in the optimisation space. As shown by the example in Figure 5, where the ISG is the gray plane labelled "P", the ISG is thus completely integrated with the library.

During code generation, DFG operations are refined until they are instances of ISG operations, so they can be executed by the processor. Each operation$\text{o} {\text{∈ V}}_{\text{O}} \text{: type(} \text{o} \text{) ∈} \text{L}$ is replaced by a refined operation *r* such that :$\text{type(} \text{r} \text{) =} \text{i} \text{∧} \text{i} {\text{∈ V}}_{\text{I}} \text{∧} \text{i} \text{is a subtype of type(} \text{o} \text{)}$

### Binding data dependencies

Consider a data dependency between two refined DFG operations *r*₁ and *r*₂, with corresponding value_{*1*} *v*_{V} ∈ V. Assume that the DFG operations are bound by the code generator to the ISG operations :${\text{i}}_{\text{1}} \text{= type(} {\text{r}}_{\text{1}} \text{) and} {\text{i}}_{\text{2}} \text{= type(} {\text{r}}_{\text{2}} \text{).}$

The function **output**(*i*, *n, s)* returns the storage element on which *i* writes its *n*-th output during operation stage *s* and the function **input**(*i*, *n, s*) returns the storage element from which *i* reads its *n*-th input during operation stage *s*.

To simplify the notation, it is assumed in the following that the respective integers *n* and *s* are chosen according to the data dependency under consideration.

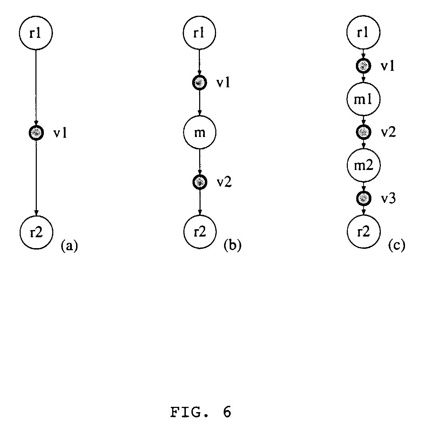

The code generator has different alternatives to bind a data dependency to the ISG. If a data dependency is bound to a path in the ISG that does not include a static storage element, it will result in a fixed time constraint between the involved DFG operations. It is therefore called a direct data dependency. Figure 6(a) shows the binding of a data dependency where :$\text{output(} {\text{i}}_{\text{1}} \text{,} \text{n, s} \text{) = input(} {\text{i}}_{\text{2}} \text{,} \text{n', s')} \text{=} \text{t; t} {\text{∈ V}}_{\text{T}} \text{.}$

Value *v*_{*1*} is then bound to the transitory *t,* denoted **carrier**(*v*_{*1*}) = *t.* However, in the more general case with **output**(*i*_{*1*}, *n, s)* ≠ **input**(*i*_{*2*}, *n', s'),* the code generator has to add a **move** operation *m* to the DFG, as shown in Figure 6(b).

Operation *m* moves its input value *v*_{*1*} along a path in the ISG, from **carrier**(*v*_{*1*}) to **carrier**(*v*_{*2*}), with *v*_{*2*} being its output value. Generally, a **move** operation is implemented by ISG operations in the set V_{I}^{move} ⊂ V_{I} that contains **copy** operations to copy values between transitories, **read** and **write** operations to access register(file)s, and **load** and **store** operations to access memories.

The set of ISG operations that are selected by the code generator to implement a particular **move** operation *m*, is returned by the function **delivery**(*m*). For the data dependency of Figure 6(b), the **move** operation will be implemented by a series of **copy** operations, according to following equations (for operations that have one input and one output, **input**() and **output**() need only two arguments) :$\text{delivery(} \text{m} \text{) = {} {\text{c}}_{\text{1}} \text{,} {\text{c}}_{\text{2}} \text{, ...,} {\text{c}}_{\text{n}} {\text{} ⊂ V}}_{\text{i}} {\text{}}^{\text{move}}$$\text{carrier(} {\text{v}}_{\text{1}} \text{) = output(} {\text{i}}_{\text{1}} \text{,} \text{n, s} \text{) = input(} {\text{c}}_{\text{1}} \text{,} {\text{s'}}_{\text{1}} \text{) =} {\text{t}}_{\text{0}}$$\text{∀k:1 ≤ k < n : output(} {\text{c}}_{\text{k}} \text{,} {\text{s}}_{\text{k}} \text{) = input(} {\text{c}}_{\text{k+1}} \text{,} {\text{s'}}_{\text{k+1}} \text{) =} {\text{t}}_{\text{k}}$$\text{carrier(} {\text{v}}_{\text{2}} \text{) = input(} {\text{i}}_{\text{2}} \text{,} \text{n', s'} \text{) = output(} {\text{c}}_{\text{n}} \text{,} {\text{s}}_{\text{n}} \text{) =} {\text{t}}_{\text{n}}$$\text{{} {\text{t}}_{\text{0}} \text{,} {\text{t}}_{\text{1}} {\text{, t}}_{\text{2}} \text{, ...,} {\text{t}}_{\text{n}} {\text{} ⊂ V}}_{\text{T}}$

In Figure 6(c), an allocated data dependency is shown. Such a data dependency is bound to a path in the ISG that includes a static storage element. It also holds for an allocated data dependency that **output**(*i*_{*1*}, *n, s)* ≠ **input**(*i*_{*2*}, *n', s'*), but now two move operations *m*_{*1*} and *m*_{*2*} are added to the DFG by the code generator. Operation *m*_{*1*} moves *v*_{*1*} from **carrier**(*v*_{*1*}) ∈ V_{T} to **carrier**(*v*_{*2*}) ∈ V_{R} ∪V_{M} and*m*_{*2*} moves *v*_{*2*} to **carrier**(*v*_{*3*}) ∈ V_{T}.

Because *v*_{*2*} is bound to a static storage element, **delivery**(*m*_{*1*}) will now contain a **write** or a **store** operation and analogously **delivery**(*m*_{*2*}) will contain a **read** or a **load** operation. Equations similar to equations (2) to (6) can be written down for each of these **delivery**() functions.

### Correctness constraints of bundles

A ***bundle*** is defined as a set of DFG operations that are bound to the ISG and for which following properties hold. Two operations that have a direct data dependency will belong to the same bundle and two operations having an allocated data dependency must be in different bundles. Because of the direct data dependencies, the timing relations between operations in a bundle are fixed and will be the same in the final schedule. Consequently, operations in a bundle may not have encoding conflicts nor hardware conflicts with each other, for any of their operation stages. The code generator can prevent conflicts by changing a direct data dependency into an allocated data dependency, thereby removing the corresponding time constraint and splitting the bundle.

In the remainder of this paragraph, some definitions are introduced to eventually define formal correctness constraints for bundles.

Let the resources that an operation *r* ∈ V_{O} uses during operation stage *s* be given by$\text{resources(} \text{r, s} \text{) = {} \text{t} {\text{∈ V}}_{\text{T}} \text{|∃} \text{n} \text{:} \text{t} \text{= output(type (} \text{r} \text{),} \text{n, s} \text{)}.}$

The enabling condition needed in operation stage *s* for operation r is given by **enabling**(*r, s*). The functions **resources**(*m, s*) and **enabling**(*m, s*) for a **move** operation *m* are also defined and respectively yield the appropriate outputs and enabling conditions of ISG operations *c* ∈ **delivery**(*m*). Below, the symbol *o* will be used, meaning either a refined operation *r* or a **move** operation *m*.

The function **resources**(*o, s*) can be seen as an access function to a reservation table for operation o (P.M. Kogge, "The Architecture of Pipelined Computers", Advanced Computer Science Series, McGraw-Hill Book Company, 1981). It returns the resources that must be reserved by the code generator for operation *o* at operation stage *s*. Similarly, the code generator must reserve the instruction register for operation *o*, so that at operation stage *s* it contains one of the instructions returned by **enabling**(*o, s*).

Further, the functions **time**(*o*, *s)* and **time**(*B*, *s*) are defined to give the absolute time on which stage *s* of respectively operation *o* or bundle *B* is executed. In analogy to an operation stage, a bundle stage is defined as the time step relative to the execution start of the corresponding bundle. The function **stages**(*o*) returns the operation stages where operation *o* claims either a resource or an enabling condition and the function$\text{stages(} \text{B} \text{) = {s|∃} \text{o} \text{∈} \text{B} {\text{,∃s}}_{\text{o}} \text{∈ stages(o):time(} \text{B} \text{,} \text{s)=} \text{time(} {\text{o, s}}_{\text{o}} \text{)}}$ returns the stages where the bundle *B* claims either a resource or an enabling condition.

Finally, the predicate **direct**(*o*_{*i*}, *o*_{*j*}) is defined to indicate whether *o*_{*i*}*, o*_{*j*} ∈ V_{O} have a direct data dependency and **allocated**(*o*_{*i*}, *o*_{*j*}) to indicate an allocated data dependency.

At this point, the correctness constraints for bundles can be formalised :$\text{constraint (7) :} {\text{∀o}}_{\text{i}} {\text{, o}}_{\text{j}} {\text{∈ V}}_{\text{o}} {\text{, o}}_{\text{i}} \text{∈} {\text{B}}_{\text{i}} {\text{, o}}_{\text{j}} \text{∈} {\text{B}}_{\text{j}} \text{: direct(} {\text{o}}_{\text{i}} \text{,} {\text{o}}_{\text{j}} \text{) ⇒} {\text{B}}_{\text{i}} \text{=} {\text{B}}_{\text{j}}$

Constraint (7) expresses that two operations having a direct data dependency must belong to the same bundle. Two operations having an allocated data dependency must be in different bundles :$\text{constraint (8) : ∀} {\text{o}}_{\text{i}} \text{,} {\text{o}}_{\text{j}} {\text{∈ V}}_{\text{o}} {\text{, o}}_{\text{i}} \text{∈} {\text{B}}_{\text{i}} {\text{, o}}_{\text{j}} \text{∈} {\text{B}}_{\text{j}} \text{: allocated(} {\text{o}}_{\text{i}} \text{,} {\text{o}}_{\text{j}} \text{)} {\text{⇒ B}}_{\text{i}} \text{≠} {\text{B}}_{\text{j}}$

Because the timing relations between operations in a bundle are fixed and will be the same in the final schedule, operations in a bundle may not have hardware conflicts nor encoding conflicts with each other, for any of their operation stages. This is formalised by the following two constraints :$\text{constraint (9) : ∀} {\text{o}}_{\text{i}} \text{,} {\text{o}}_{\text{j}} \text{∈} \text{B} \text{, ∀s ∈ stages(} {\text{o}}_{\text{i}} \text{), ∀} \text{s} \text{' ∈ stages(} {\text{o}}_{\text{j}} \text{) :} \text{time(} {\text{o}}_{\text{i}} \text{, s} \text{) = time(} {\text{o}}_{\text{j}} \text{, s'} \text{) ∧} {\text{o}}_{\text{i}} \text{≠} {\text{o}}_{\text{j}} \text{⇒ resources(} {\text{o}}_{\text{i}} \text{, s} \text{) ∩ resources(} {\text{o}}_{\text{j}} \text{, s'} \text{) = φ}$

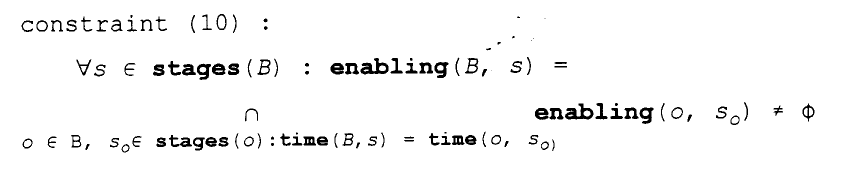

The last constraint also defines the enabling condition of a bundle at stage *s;* its resources at stage *s* are given by

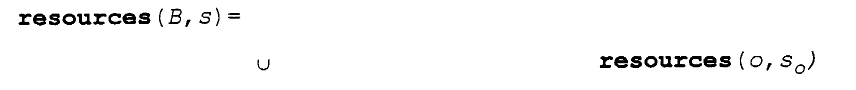

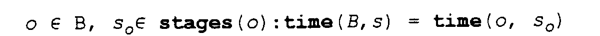

### Conflict constraints between bundles

As all timing relations in a bundle are fixed, the scheduler can use a conflict model between bundles. Therefore conflict constraints are formulated that must hold for a set β of bundles to be conflict free (with c being a control step in the resulting schedule) :$\text{constraint (11) : ∀} {\text{B}}_{\text{i}} \text{,} {\text{B}}_{\text{j}} \text{∈ β, ∀} \text{s} \text{∈ stages(} {\text{B}}_{\text{i}} \text{), ∀} \text{s} \text{' ∈ stages(} {\text{B}}_{\text{j}} \text{) :} \text{time(} {\text{B}}_{\text{i}} \text{, s} \text{) = time(} {\text{B}}_{\text{j}} \text{, s'} \text{) ∧} {\text{B}}_{\text{i}} \text{≠} {\text{B}}_{\text{j}} \text{⇒ resources(} {\text{B}}_{\text{i}} \text{, s} \text{) ∩ resources(} {\text{B}}_{\text{j}} \text{, s'} \text{) = φ}$

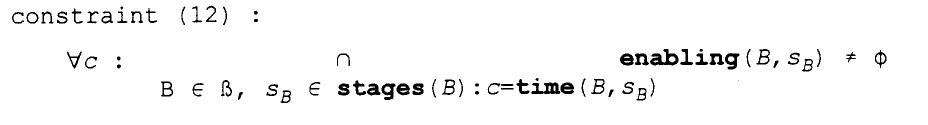

### Code selection and delayed binding

As said above, the code generator binds G_{DFG} onto G_{ISG} in subsequent phases. In a first phase, it is decided on which data dependencies will become direct data dependencies, or equivalently, the DFG operations are partitioned into groups, each becoming a bundle eventually.

This phase matches graph patterns in the DFG onto graph patterns in the ISG. The DFG operations are refined according to relation (1) and direct data dependencies are bound, as shown in Figure 6(a) and (b), and according to constraints (2) to (6). The code selection tool may add some move operations to the DFG for this. The allocated data dependencies are not yet bound, but it is verified that each bundle input and output can access static storage. It is made certain that the correctness constraints for bundles, constraints (7) to (10), are not violated.

However, several binding alternatives may still be possible. In this phase only the partitioning of the DFG operations into bundles is done; the exact binding decision is delayed to a subsequent task. The design, both the DFG and the ISG, is also taken to a higher level of abstraction. For each subgraph in the DFG that is formed by the partitioning above, a new abstract operation *g* ∈ *L* is created, and the subgraph is replaced by an instance of operation *g.* For each valid binding of this subgraph, a new operation *b* ∈ V_{I} *⊂ L* is created. Operation *b* is inserted in the ISG and is a subtype of operation *g* in the type hierarchy of *L.* The enabling condition(s), the resources and the timing of operation *b* can all be derived from the original ISG and are annotated with *b.*

In this way the same relations are obtained as depicted in Figure 5, but with a DFG and an ISG of much lower complexity. Specific binding possibilities, to be decided on in a subsequent phase, are directly accessible in the library.

### Register allocation

In a second phase, the (allocated) data dependencies between bundles are bound. This means that for each operation *g* an implementation *b* is chosen and move operations are added at their inputs and outputs to access static storage, while satisfying constraints (7) to (10). In addition to the simple paths considered in Figure 6(c), also paths visiting more than one static storage can be needed, for example to spill a register to memory and to reload it. In the latter case, new bundles are inserted that only consist of single **move** operations.

Two important characteristics of the ISG model, which pattern-based models are lacking, are :
- Its graph structure allows the binding problem of values to be formulated as a ***path-search*** problem.
- It supports an ***incremental*** construction of the eventual instructions, by combining elementary actions (either operations or moves) into bundles. By associating **resources** and **enabling** attributes with every elementary action, and by defining how these attributes can be combined, an accurate conflict behaviour is available for every partial bundle.

These two characteristics are essential for the register allocation tool, to evaluate the impact of the different routing alternatives for a single data dependence on both the global register and timing cost.

### Scheduling

After register allocation, all operations and values are bound to the ISG, but they must still be bound to time. During this scheduling phase, for each operation also an instruction is chosen from its enabling condition. The objective is to minimise cycle count, thus as many operations as possible should be scheduled in parallel, while satisfying the conflict constraints (11) and (12).

### 3. ADDITIONAL MODELLING ISSUES.

### Control flow operations

The basic idea behind modelling the decision making capabilities of a processor in the ISG is to introduce abstract ***control flow operations****.* Control flow operations in the ISG are much like data-path operations. They just model the control unit of the processor instead of the data path. A jump operation, for example, assigns a new value to the program counter (PC).

Other operations, such as a call to a subroutine or a hardware do loop have a more complex behaviour, the details of which are not put in the ISG as they are unneeded for code generation. Instead an abstract control flow operation is inserted in the ISG and its behavioural model is stored elsewhere and made available to the simulator.

Data-path operations in a processor usually do not only generate a result, but also set flags depending on properties of the result. These flags are stored in a status register and can be used by the control flow operations to implement decision making. The generation and the consumption of these flags is modelled in the ISG, as it leads to operation dependencies which are important for code generation.

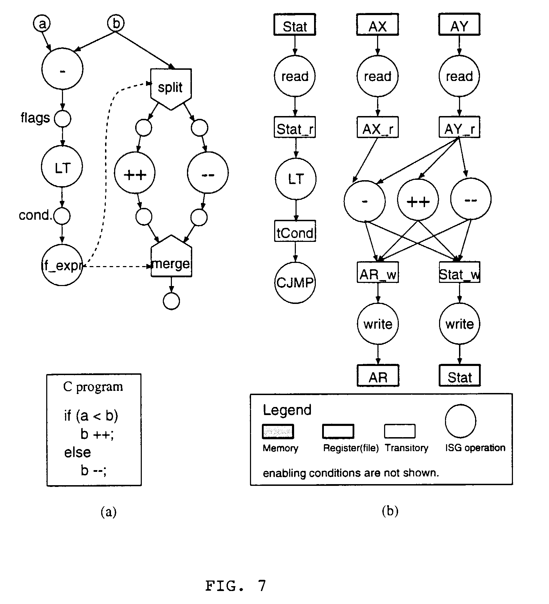

For the purpose of this description, it can be assumed that the application program is represented by a control data flow graph (CDFG), without introducing branch labels or other references to the PC. A small "C" program is shown in Figure 7(a) together with the resulting **if-then-else** construct in the CDFG. The condition is obtained by subtracting value **b** from value **a** and the resulting flags are input of the less-than (**LT**) operation that yields a boolean value (a bit) needed by the **if_expr** operation. This **if_expr** operation selects between the **then** (if the boolean value is true) and the **else** (if the boolean value is false) paths in the CDFG, as indicated by the dashed arrows in Figure 7(a). This CDFG can be mapped on the small ISG shown in Figure 7(b) : values **a** and **b** are respectively put in registers **AX** and **AY**, and the CDFG operations are mapped on the ISG operations with a matching label (i.e. labels consisting of the same symbol). Thus, the ISG must also contain an **LT** operation. The **if_expr** operation is refined to a conditional jump operation (**CJMP**) and mapped to the corresponding operation in the ISG. Together with a non-conditional jump that is added in a later compilation phase, the CJMP operation implements the selection of either the **then** or the **else** path in the **if-then-else** structure.

### Conditionally executable instructions

A conditionally executable instruction enables some ISG operations if a certain condition is true and is otherwise equal to a NOP instruction that does not enable any operation.

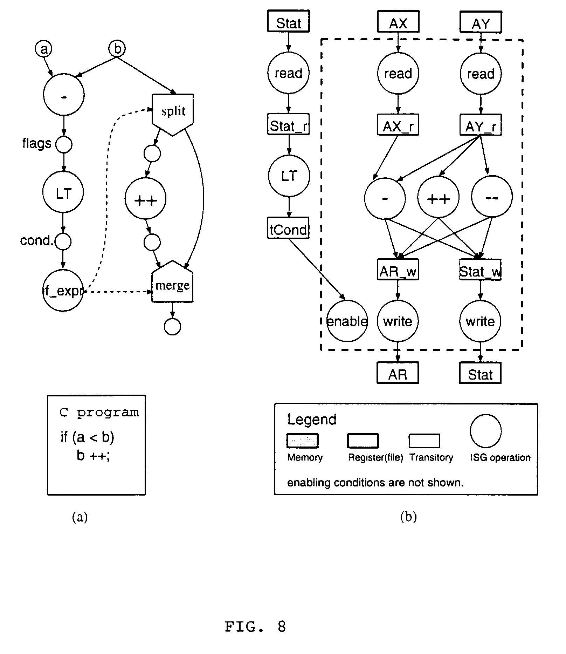

A conditional construct like in Figure 7(a) can not be executed by a conditional instruction, because also something must be done when the condition is false. Figure 8(a) contains a similar C example and the corresponding **if-then** CDFG construct that can be implemented by a conditionally executable instruction. Not only the increment operation is conditional, but also the read and write operations of the operands and result(s) are conditional, and this must be modelled in the ISG. So what is needed is a way to express that an ISG operation like the **LT** operation enables (or disables) ***a group*** of other ISG operations. For this purpose a macro-node concept is introduced in the ISG.

A macro-node is a group of ISG operations and is enabled by the **enable** operation that it contains, when that **enable** operation receives a **true** as input. Other ISG operations contained in a macro-node are active if ***both*** their macro-node is enabled **and** their enabling condition is satisfied.

Figure 8(b) contains a small ISG with a macro-node that is shown as a dashed rectangle. All operations drawn in the rectangle are in the macro-node.

The code generator recognises that the pattern of Figure 8(a) can be mapped onto an either the ISG shown in Figure 7(b) or the ISG shown in Figure 8(b). In the latter case, the **if_expr** operation will be refined to an **enable** operation, while in the former case it would be refined to a **CJMP** operation.

### Residual control

When the execution of an operation does not solely depend on the instructions in the ***instruction register*** but also on some bits in a ***mode register****,* that operation is said to be residually controlled. A common example in DSP processors is a ***saturation*** bit, indicating whether an adder must perform saturating or normal additions, which have a different behaviour when an overflow would occur.

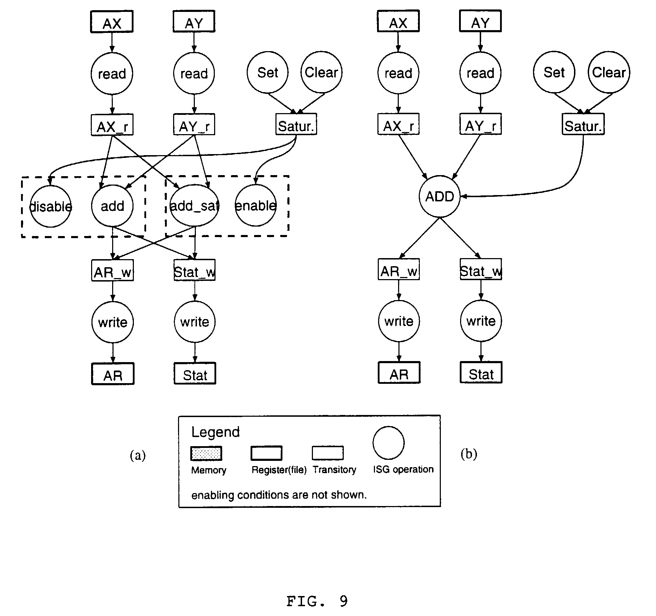

A residually controlled operation can be modelled by splitting it in several conditionally executable operations, as shown the ISG of Figure 9(a). There two operations are inserted in the ISG, the **add** has non-saturating behaviour and the **add_sat** saturates. Each of them is in a macro-node with either an **enable** or a **disable** node connected to the register containing the saturate-bit. A **disable** node enables its macro-node when it receives a **false** as input.

Another way of modelling residually controlled operations is shown in the ISG of Figure 9(b). There an **ADD** operation ***with an additional input*** is inserted in the ISG. Its behaviour is such that it performs normal additions when the third input is **0** and performs saturated additions when the third input is **1**. The **add** and **add_sat** operations are expanded by the front-end into **ADD** operations with the third input connected to the appropriate constant, **0** or **1**. This way of modelling allows to elegantly handle the setting and clearing of the saturation bit, just like any other constant that must be present at an operation input and is therefore used in the preferred embodiment.

### Data types

A storage element physically contains a bit string of a certain length, but on a typical DSP processor not all storage elements have the same bit width.

For example, most storage elements of the ADSP-2111 from Analog Devices have a word length of 16 bit, but the address registers are only 14 bit long. Sometimes the behaviour of a processor operation presupposes a data type that is more specific than a bit string, such as e.g. an unsigned integer or a signed fractional number. In the ADSP-2111 from Analog Devices for example, memory addresses, contained in address registers, are supposed to be unsigned integers, while address modifiers, contained in index registers, are supposed to contain signed integers. Each storage element in the ISG is thus annotated with its specific data type, as for example the **num** data type in Figure 3.

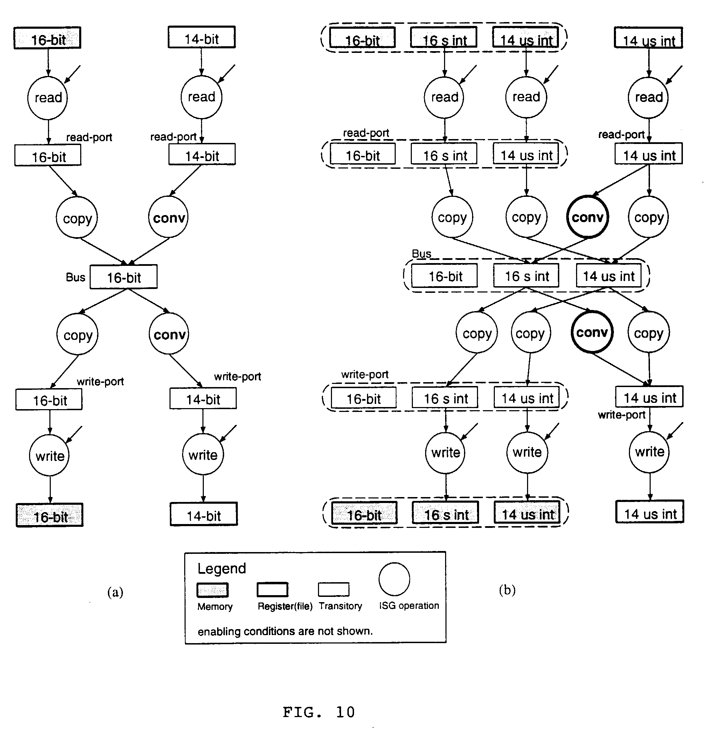

To spill a 14 bit register to a 16 bit wide memory, a conversion from 14 to 16 bit is performed while putting the register contents on the data bus. This conversion involves a zero or a sign extension, depending on the assumed data type in the register. This can be modelled in the ISG as shown in Figure 10(a), where a path exists from the 14 bit register to the memory and back. In the latter path, from memory to register, a conversion is done to transform the 16 bit value to a 14 bit value. However, the two most significant bits are lost during this conversion, which is potentially unsafe. While mapping data dependencies on the ISG, the code generator must check on the type safety of move operations, because a move operation then also may contain data type conversions. Therefore each value must be annotated with its data type and its alignment on the storage element.

Additionally, the code generator must then know how each ISG operation possibly changes this data type or alignment.

In the preferred embodiment of the present invention, another approach is used to guarantee that only type safe data moves are generated. This approach simplifies the data type checks for the code generator, at the cost of a larger ISG. The basic principle is that the code generator will never add any move operation to the DFG that is changing a data type (i.e. all operations in V_{I}^{move} preserve their input data type). In fact, the connectivity of the ISG is used to make abstraction of any ***reversible*** type conversion. Each storage element is annotated with a specific data type and may only carry values of that data type. If in reality a physical storage element can carry different data types, an additional storage element carrying that specific data type is inserted for each of them. Such an additional storage element is not a resource, but an alias of the physical storage element and defined by an ***alias relationship****.* The **resources**() function above-described will never return aliases, but always the corresponding physical storage elements, which are the ones used to check for hardware conflicts. Figure 10(b) contains the example of Figure 10(a) modelled in this way, where aliases and their physical storage element are put in a dashed box. For example, when a 14 bit unsigned integer must be spilled, it is spilled to a memory alias with the same data type. In case that the application requires the data type of a value to change, the DFG will contain a conversion operation for this. This operation can then be mapped onto a conversion operation with the appropriate behaviour as for example the **conv** operation in Figure 10(b).

### Record data types

Certain registers on a processor have an internal structure, they are constructed out of other registers that are also separately addressable. The accumulator register of most fixed-point DSP processors is an example of such a ***record storage element****.* In the example processor described earlier the accumulator register MR is the concatenation of the two registers MR0 and MR1.

A record storage element must have a ***record data type****.* The elements of the record data type completely match the elements of the record storage element. Indeed, the basic types of the record data type are assigned to the composing storage elements of the record storage element. Aliases can as well be defined for record storage elements as for the composing storage elements, as above-described.

The internal structure of a record storage element is captured in the ISG by a structural relationship between the storage element and its composing storage elements. This defines the storage element to be an alias of the concatenation of its composing storage elements and models the overlap of the storage elements. The advantage of defining a record storage element in this way is that it can be accessed as a whole, while it also allows to access the composing storage elements separately. For an operation that occupies a record storage element, the **resources**() function above-described will thus return the physical storage elements that compose the record storage element.

### Functional units

Functional units in a conventional net-list model are defined as units having ports which are connected to nets. Operations are defined on these functional units, with their arguments bound to the ports. In the ISG, arguments of operations are directly bound to transitories. Functional units then are optional, they are just a set of operations that are assigned to some data path operator. The specification of functional units is particularly useful when a net-list must be derived from the ISG. In Figure 3, two functional units can be found : alu and sh.

### Specification of the ISG

In principle, a designer could directly provide the full ISG description to be used by the code generator and instruction simulator programs. Due to the amount of detail in a typical ISG, this would, however, be cumbersome. Instead, a more compact and user-friendly design entry level is provided by specifying a processor with the nML description formalism described in Fauth, Van Praet and Freericks, "Describing instruction set processors using nML", Proc. Europeen Design and Test Conference, Paris, France 1995, and using the so-specified processor as a front-end to the ISG model of the present invention. Other possible front-end descriptions to the ISG model of a processor include a VHDL-description, a C-description or the netlist of said processor. In the sequel, for the purpose of teaching the present invention, the example of nML description is detailed.

Although nML contains all the information needed for code generation, it is not a processor model. It does not explicitly show the connectivity of the data-path, nor does it allow efficient look up of all operations with a certain behavior. The nML description formalism is designed to facilitate the task of describing a processor. Its grammar structure aids a human to have an overview of the performed actions in each instruction part, but cannot be efficiently used by code generation phases. Hence, the need exists for the instruction set graph with a structure fitting the graph of the application to be programmed and with the type of hierarchy which is useful for a computer program.

The nML front-end is partly based on prior art (see for example, the description concepts of nML set forth below) enhanced with new developments (see for example, the description of adding a structural skeleton to nML, set forth below) to contain all information needed to generate the complete ISG.

### Basic Concepts of nML

An nML description is written at the level of a programmer's manual. Therefore, most implementation details of the actual machine are hidden, but it contains all information needed for code generation. An enumeration of both the memory locations and-the instruction set of the processor are the basic ingredients of an nML description.

Complex architectures may allow hundreds of legal combinations of operations and addressing modes to compose the instruction set. The size of a description can however be reduced by introducing hierarchy and by sharing similarities among a variety of instructions. In an nML description, a grammar based approach is used for that purpose. The production rules in the grammar introduce the structure of the instruction set into the processor description.
- OR-rules are production rules which indicate alternative partial instructions, a different interpretation of fields in the instruction word.
- AND-rules indicate the composition of orthogonal partial instructions into a bigger part, a concatenation of independently controllable fields. Also the leafs in the hierarchy are AND-rules.

Each of the strings which can be derived from the grammar symbolizes one instruction of the processor. By itself, such a string contains no useful information. All semantic aspects are held in the (predefined) attributes of the production rules. The **action** attribute contains the behavior of the instruction part, described in terms of the composing rules or with register transfers. The **image** attribute holds the values to set the instruction word fields and the **syntax** attribute describes the assembly language syntax.

In nML, addressing modes are defined as **mode**-rules having an extra **value** attribute. This value is an expression that results in a memory location. When a **mode**-rule is referenced in the **action** attribute- of another rule, it is replaced by its value. A **mode**-rule can be either an AND-rule or an OR-rule.

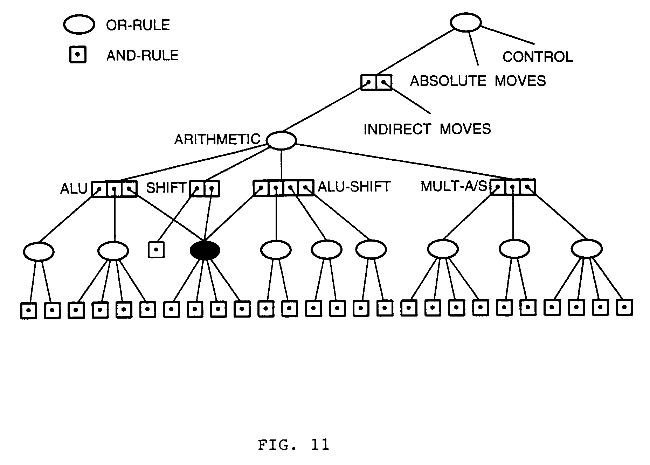

The hierarchy introduced by the attributed grammar makes an nML description very concise, easy to write and easily maintainable. The structure in the nML description of the example processor of the present invention is shown in Figure 11.

An nML description is typically constructed by analyzing the instruction set of the target machine proceeding top-down. For the present example, the three formats are easily reflected in the nML description by capturing the top-level classification in an OR-rule.
**opn instruction = computemove | moveaps | ctrl**

Either a computation with a data move in parallel, a sole data move with absolute addressing or a control-related instruction can be executed. By further zooming into the first category of instructions, two orthogonal parts are found (i.e., two parts of the instruction that can be controlled independently). This is described in an AND-rule:
**opn computemove(c:compute,m:move)**

The parts of the instruction that are composed with this rule are listed in the parameter list. The declaration of a paramater consists of an instantiation name and a reference to some other rule or to a data type (in case of an immediate operand). The description of each orthogonal part is encapsulated in a rule of its own. It often occurs that such a part is even referred to by more than one rule. In our example, the operand class {AX, AR, MRO, MR1} is subsumed in an addressing mode rule:
**mode lopd = AX | AR | MRO | MR1**

This rule is represented by the highlighted node in Figure 11. There are three references to this rule. One reference for *opd1* of *alu,* one for *opd* of *shift* and one for *opd1* of *alu-shift.*

For nML, the storages represent the state of the machine and an instruction can be seen as a state transition function. This information is stored in the **action** attribute. Its value consists of a sequence of statements. In nML, maximum possible parallelism is implicit. A statement must either be an assignment or a conditional as shown in the following two rules. (There is also an if-then-else clause).

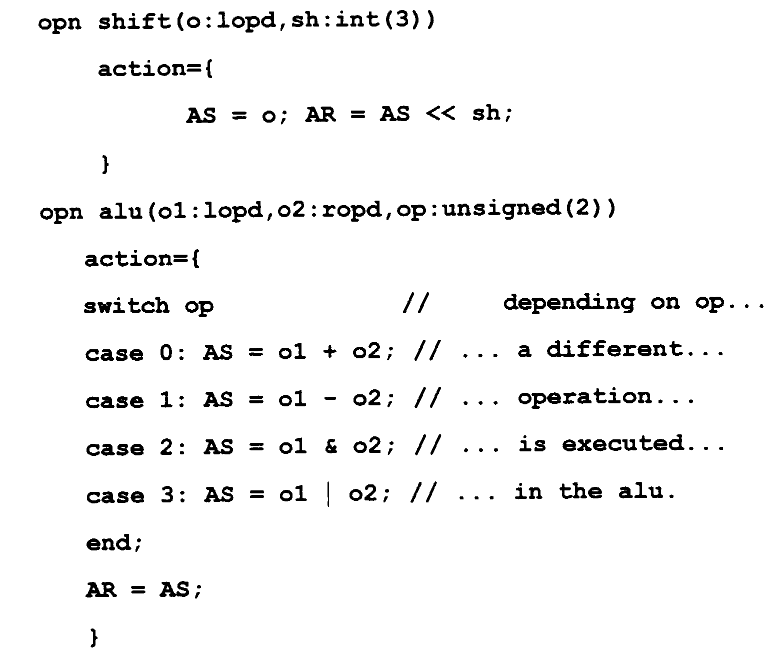

The predefined operators to form expressions include the common "C" operators plus some DSP-related extensions (e.g., exponentiation, bit rotation, bit string selection and concatenation). Other operators are easily added.

The definition of an attribute can include references to attributes defined by the parameters of the rule.
**opn computemove(c:compute,m:move)**
**action={c.action; m.action;}**

The above defines the **action** of computemove as the sequence of the **actions** of the instances of **compute** and **move**.

The binary coding and the assembly language mnemonic are captured in the **image** resp. the **syntax** attribute. The value of the **image** attribute is a bit string, and the value of the **syntax** attribute is a string.
**opn computemove(c:compute,m:move)**
**image="O"::c.image::m.image**
**syntax=format(**"%**s** ∥ %**s**",**c. syntax,m.syntax)**

The **image** attribute attached to this rule expresses that the binary code for this instruction part consists of a fixed single bit prefix "0" concatenated with the **image** attributes of the two components. The definition of the **syntax** attribute is similar. (The function **format** resembles the "C" library function **printf**).

In addition to the aforementioned **opn** rules, there are rules to support the description of addressing modes. These **mode** rules behave similar to **opn** rules but have an effective address expression. The parallel data moves of our example processor use indirect addressing to compute the effective address.
**mode indinc (j:card(2),k:card(2)) = m [r[j]]**
**action={r[j]=r[j]+[k];}**
**image="0"::j::k**
**syntax=format("(R%d++I%d)"j,k)**

This rule specifies the effective address as well as some code that is used to update the address register. It is used in contexts such as:
**mode adrmode = indinc** | **inddec**
**opn load (r:regm,a:adrmode)**
**action = { r=a; a.action; }**
**image = "00"::r.image::a.image**

A storage element is declared by giving a name, the size and the element type.
For example:
**mem m [1024**,**int(16)]**
**reg r [4, fix (1,31)]**

This defines a memory **m** of 1K with elements of 16 bit integer numbers and a four element register file **r** of 32 bit fixed-point numbers.

### Adding a structural skeleton to nML

The foregoing discussion of modelling hardware conflicts via transitories explained how transitories model all possible hardware conflicts in the ISG. These transitories have also been added to the nML formalism, to be able to to use it as a front-end to the ISG model. A transitory is declared like a register or a memory, but with the key-word **trn**. An nML description starts with specifying a structural skeleton of the processor at the level desired in the ISG, with exception of most read/write ports of static storage elements (see discussion of modelling hardware conflicts via transitories). These are automatically created in the translation from nML to ISG.

Instead of complete register transfers, the **action** attributes now contain operations connected to the storage elements to express the behavior of a partial instruction. In this way, it is possible to specify, for example, different operations writing to the same transitory.

The operations in an nML description can be annotated with the functional unit on which they are executing, and can be attributed with timing information. By means of extra attributes to either the operations or the storage elements, it is in fact possible to express all information needed in the ISG.

For the description of memory and register read/write operations with different addressing mechanisms, the **mode** rules are used. However, the semantics of these **mode** rules have been changed for a better modelling of hardware conflicts. When a **mode**-rule is referenced in the **action** attribute of another rule, a distinction is made between two cases. The value can be evaluated as an l-value (a left-value, i.e., the definition of a location to be written) or as an r-value (a right-value, i.e., the definition of a location to be read). An r-value translates into a **read** operation between the involved static storage element and a transitory modelling its read port; an l-value into a **write** operation between the static storage element and its write port. Each value can be annotated with the read port and the write port to be used in the respective evaluations.

The refined semantics of the **mode**-rules make that each addressing mode needs only to be described once, while providing the precise modelling of possible hardware conflicts for both the **read** and **write** operations.

### Use of the Model by the Code Generation and Instruction Set Simulation Programs

All the concepts explained are implemented in a retargetable compiler which is detailed in this section. For purposes of teaching the compiler CHESS is chosen as an example of a retargetable compiler. A retargetable compiler needs two inputs:
1. A specification of the target processor.
2. An application program, for example written in C.

On the one hand, the processor specification consists of a description of the data types and operations that are supported in the instruction set of the processor. The processor specific data types and operations are specified in the C language.

On the other hand, the processor specification contains a description of the processor architecture and instruction set. This is specified preferably in the nML language.

It is the task of the front-end of the retargetable compiler to translate the C and nML descriptions into internal formats used by the retargetable code generator. The processor primitives of the library *L* are stored in the LIB format (.lib files), the architecture and instruction set description is stored as an instruction set graph or ISG (.isg files), and the non-primitive functions of the processor model and of the application program are stored in a control data flow graph or CDFG format (.cdfg files).

It is then the task of the back-end of the retargetable compiler, the retargetable code generator, to perform the code generation phases using these internal formats.

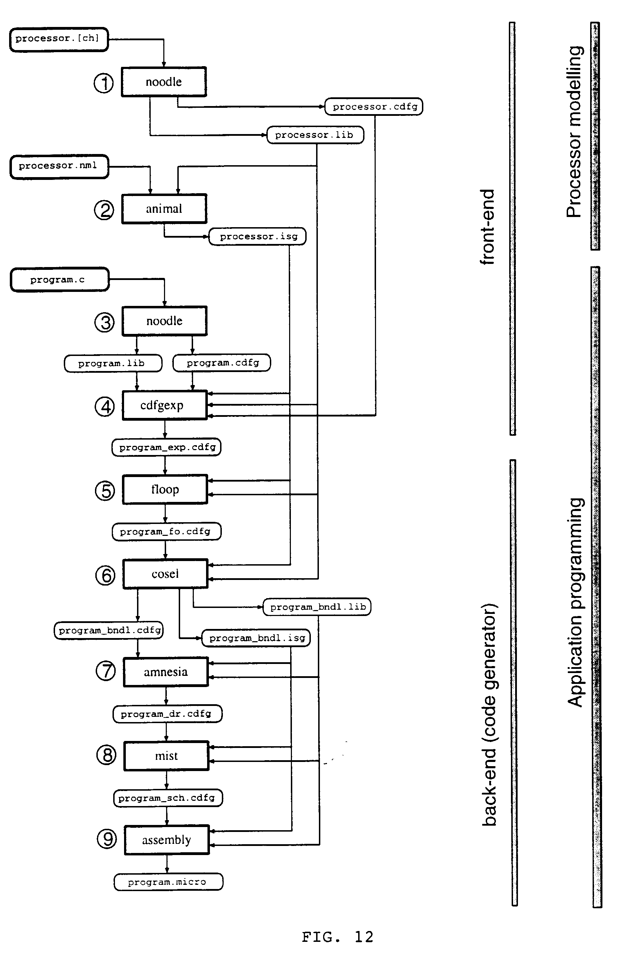

An overview of the retargetable compiler is given in Figure 12. The translation of processor and program specifications into the internal models takes place in the first four steps, after this the code generation phases are executed. All steps are explained in the following :
1. The processor specific operations are specified in the C language and this specification is translated into the LIB format by means of the **noodle** tool. For primitive operations (i.e. operations supported by the instruction set of the processor), only an entry in the LIB is generated; for non primitive operations, also a CDFG view is generated.
2. The processor instruction set and RT-level architecture are specified in the nML language, and are translated into an ISG by means of the **animal** tool. Here it is checked that only primitive operations are used in the nML actions. In the ISG, operations are attributed with connectivity and instruction encoding information.
3. The application program is specified in the C language, and the main function is translated into a main CDFG. If other functions are defined, then these are translated into a separate CDFG and a program specific library is generated for them. For this step, the **noodle** tool will again be used.
   Note that the specification file containing the processor specific operations (processor.h) is included in the application program file by means of an #include directive.
4. As a last step in the front end all non-primitive operations are expanded down to the level of primitives by means of an expansion tool **cdfgexp,** and the resulting CDFG is then used as the input for the code generator.
5. This is the first phase of the code generator. Some standard flow graph transformations are done by the **floop** tool to optimise the CDFG for later mapping on the ISG. These transformations include constant folding, strength reduction, common subexpression elemination, loop invariant code motion and reduction of induction variables.
6. The **cosel** tool implements the code selection phase as explained above. The several binding possibilities which are then still possible, are annotated in the LIB and ISG formats. This makes the generation of new .lib and .isg files necessary.
7. The register allocation phase is performed by the **amnesia** tool, as also explained above.
8. The **mist** tool schedules the CDFG and thus binds operations to time steps, choosing an instruction for each operation from its enabling condition, see also above.
9. The CDFG is then translated to binary code by the assembly tool. This also includes the assignment of values to fields within a register file, and the generation of up until then unspecified addresses.

Steps 1 and 2 need to be executed once for every processor design iteration, the other steps need to be executed once for every change to the application program.

### A simulator generator based on the ISG

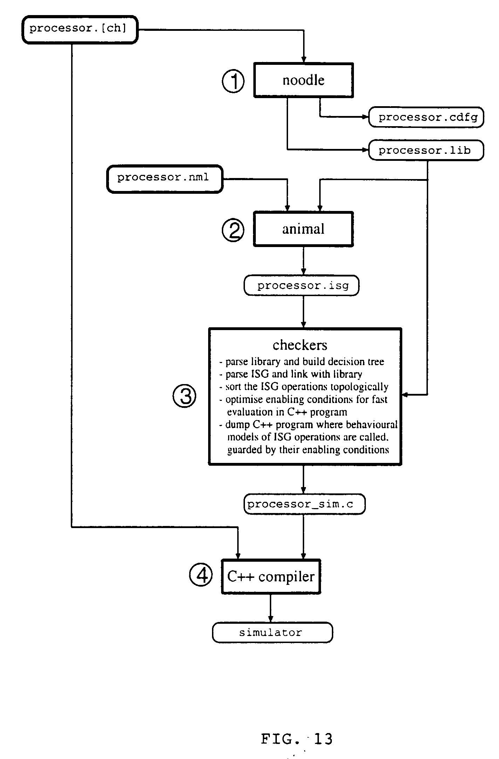

The ISG model is also used as processor model in a retargetable simulator generator. In the sequel, for the purposes of teaching, the retargetable simulator generator CHECKERS is detailed. In fact the instruction level simulator can be an executable C++ program that is automatically generated by analysing the ISG. The flow of this process is shown in Figure 13. The first two steps are completely the same as for the retargetable compiler. In a third step the ISG is analysed by the tool **checkers** to generate the C++ program. This tool topologically sorts the operations in the ISG according to their connections and optimises the enabling conditions so they can be evaluated fast. The C++ program basically is a list of calls to the functions containing the behavioural models of the ISG operations, with each call being guarded by the corresponding enabling condition. The functions containing the behavioural models are described in the processor.c file. The last step to build the simulator is to compile the C++ program together with the processor.c file with a C++ compiler. This yields the instruction set simulator.

In the preferred embodiment, the resulting instruction level simulator interpretes a stream of non-preprocessed instructions to simulate the behaviour of processor. It is also possible to input this instruction stream to the simulator generator in which case the resulting C++ program would contain a behavioural model of the processor for the given instruction stream.

### Implementation of the ISG

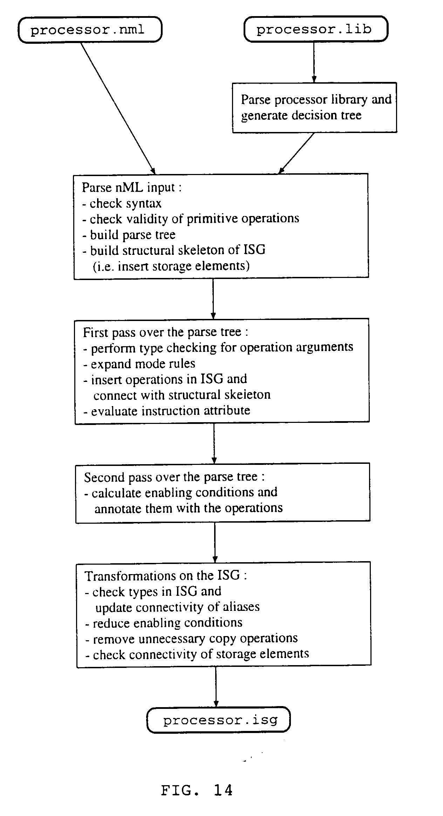

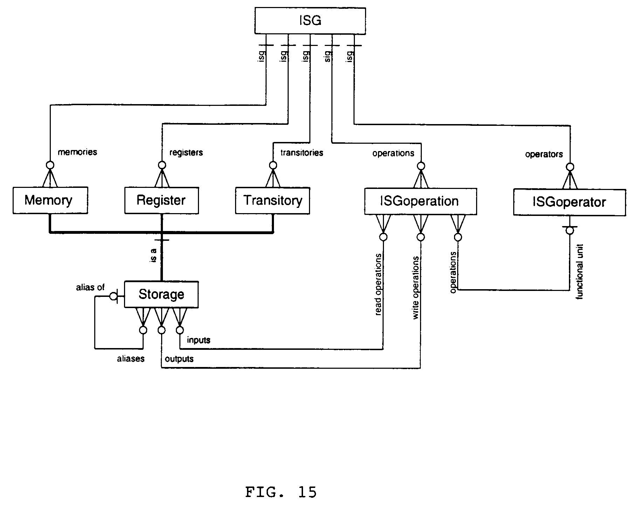

In this Section, the implementation of the preferred embodiment of the ISG is explained. The flowdiagram of the program that performs the translation is shown in Figure 14. The objects that make up the embodiment of the ISG and the relationships between these objects are captured in the information structure diagram shown in Figure 15.

### Objects of the instruction set graph

- The **ISG** object represents the instruction set graph.
- The **ISGoperation** object represents an element of the set V_{I}; and all the properties of such an element. These properties are for example the type of operation and the enabling condition of the operation.
- The **Storage** object represents an element of the set Vₛ, and all the properties of such an element. These properties are for example the capacity of the storage and the data type of the values that the storage can hold.

A storage object can be any one of the following three subtypes:
- A **Memory** object, representing a static storage element, usually with a large capacity and for which the access operations take relatively long.
- A **Register** object, representing a static storage element, usually with a small capacity and for which the access operations take much less than a machine cycle.
- A **Transitory** object, representing a transitory storage element.

This supertype/subtype relationship is indicated by the thick line in Figure 15.
- The **ISGoperator** object represents a functional unit.

### Relationships between the objects of the instruction set graph

- An **ISG** contains zero or more **Memorys,** as indicated by the memories relationship; a **Memory** belongs to exactly one ISG, as indicated by the **isg** relationship.
- An **ISG** contains zero or more **Registers**, as indicated by the **registers** relationship; a **Register** belongs to exactly one ISG, as indicated by the **isg** relationship.
- An **ISG** contains zero or more **Transitorys**, as indicated by the **transitories** relationship; a **Transitory** belongs to exactly one **ISG**, as indicated by the **isg** relationship.
- An **ISG** contains zero or more **ISGoperations,** as indicated by the **operations** relationship; a **ISGoperation** belongs to exactly one ISG, as indicated by the **isg** relationship.
- An **ISG** contains zero or more **ISGoperators,** as indicated by the **operators** relationship; a **ISGoperator** belongs to exactly one ISG, as indicated by the **isg** relationship.
- A **Storage** has zero or more **ISGoperations** that read from it, as indicated by the **read operations** relationship; a **ISGoperation** has zero or more **Storages** it reads from, as indicated by the **inputs** relationship.
- A **Storage** has zero or more **ISGoperations** that write to it, as indicated by the **write operations** relationship; a **ISGoperation** has zero or more **Storages** it writes to, as indicated by the **outputs** relationship.
- A **Storage** can be the child alias of zero or one other **Storage**, as indicated by the **alias** of relationship; a **Storage** can be the parent alias of zero or more other Storages, as indicated by the **aliases** relationship.
- An **ISGoperator** can be the functional unit on which zero or more **ISGoperations** are defined; as indicated by the **operations** relationship; an **ISGoperation** can be defined on zero or one **ISGoperators,** as indicated by the **functional unit** relationship.

## Claims

1. A method of generating code for a programmable processor comprising the steps of:
- representing said processor as a directed bipartite graph with first and second sets of vertices and with edges, said graph comprising essentially all information about the instruction set and the hardware of said processor, said first set of vertices representing storage elements in said processor, and said second set of vertices representing operations in said processor,
- linking said graph to tools and libraries required for generating code for said processor, and
- executing the required code generation phases whereby the required information about said processor is extracted from said graph.

2. The method as defined in claim 1 wherein, said edges represent valid connections between said operations and said storage elements, said connections modelling the data flow in said processor.

3. The method as defined in claim 1 adapted for evaluating the optimization phase of generating code for an application algorithm, further comprising the step of building a decision tree with vertices and branches wherein:
- vertices of said decision tree represent primitive operations, whereby said application algorithm contains instances of said primitive operations;
- said branches represent possible transformations of said primitive operations according to alternative mapping possibilities in said optimization space, and
- wherein, the set of vertices of said decision tree comprises vertices representing patterns of other vertices of said set, said patterns being defined during said code generation phases, and the second set of vertices representing operations of said processor.

4. The method as defined in claim 1, further comprising the steps of:
- representing hardware conflicts in said processor as access conflicts on said vertices representing said storage elements; and
- annotating each vertex of said second set of vertices representing operations with their enabling condition, said enabling condition representing values of the instruction register of said processor that enable the execution of the operation represented by said vertex.

5. The method as defined in claim 4 wherein, said method determines valid partial instructions, said method further comprising the steps of:
- selecting a subset of said second set of vertices representing operations;
- verifying that the intersection of the enabling conditions of all operations of said subset is not empty; and
- verifying that said subset is free of access conflicts on said storage elements.

6. The method as defined in claim 1 wherein, said storage elements are static and transitory storage elements, said method further comprising the step of representing all hardware conflicts in said processor as access conflicts on said vertices representing said transitory storage elements.

7. The method as defined in claim 1 wherein, data-types supported by a storage element are specified, said method further comprising the steps of:
- specifying different vertices representing one storage element;
- annotating each of said different vertices with a data type supported by said one storage element, and
- specifying an alias relationship between said different vertices representing said one storage element.

8. The method as defined in claim 1 adapted for representing record storage elements, said method further comprising the steps of:
- specifying a vertex representing the concatenation of several storage elements;
- annotating said vertex with a data type being a record of the data types of said storage elements;
- specifying a structural relationship between said vertex and the vertices representing said storage elements.

9. The method as defined in claim 1, adapted for representing operations of which the execution depends on a defined condition, said method further comprising the steps of:
- specifying a subset of said second set of vertices representing operations, characterized in that all vertices in said subset depend on said condition;
- specifying in said subset a vertex that is connected by an incoming edge to a vertex of said first set of vertices that represents the storage element where said condition is available;
- specifying that said operations represented in said subset can only be enabled when said condition has a specific value.

10. The method as defined in claim 4 wherein, execution times of operations are modelled, said method further comprising the steps of:
- annotating an enabling condition of said operation with the relative time step of the corresponding instruction issue with respect to the start of said operation;
- annotating said operation with the time steps relative to the start of said operation at which said operation accesses the input and output storage elements of said operation.

11. The method as defined in claim 1 wherein, said method represents a functional unit in said processor, said method further comprising the steps of specifying a subset of said second set of vertices representing operations wherein, all vertices in said subset execute on one functional unit.

12. The method as defined in claim 1 wherein, said processor includes a controller unit, and operations modelling said controller unit are represented as vertices of said second set of vertices representing operations.

13. The method as defined in claim 1 wherein, said processor has an architecture and instruction set designed for a specific class of algorithms such as digital signal processing algorithms.

14. The method as defined in claim 13 wherein, said processor is integrated in an application-specific integrated circuit.

15. A retargetable code generator for generating code for programmable processors being embedded in an electronic system comprising:
- an electronic system with an embedded programmable processor,
- first tools to build a directed bipartite graph with vertices and edges which internally represents said programmable processor, said graph comprising essentially all information about the instruction set and the hardware of said processor and having first and second sets of vertices, said first set of vertices representing storage elements in said processor, and said second set of vertices representing operations in said processor,
- second tools and libraries required to generate code for said processor, and
- means to link said graph to said second tools and said libraries, whereby the information about said processor required during code generation is extracted from said graph.

16. A retargetable code generator as defined in claim 15 wherein said first tools:
- represent hardware conflicts in said processor as access conflicts on said vertices representing said storage elements; and
- annotate each vertex of said second set of vertices representing operations with their enabling condition, said enabling condition representing values of the instruction register of said processor that enable the execution of the operation represented by said vertex.

17. A retargetable code generator as defined in claim 16 wherein said second tools:
- select a subset of said second set of vertices representing operations;
- verify that the intersection of the enabling conditions of all operations of said subset is not empty; and
- verify that said subset is free of access conflicts on said storage elements.

18. A method of simulating the execution of code on a programmable processor, said method comprising the steps of:
- representing said processor as a directed bipartite graph with first and second sets of vertices and with edges, said graph comprising essentially all information about the instruction set and the hardware of said processor;
- said first set of vertices representing storage elements in said processor;
- said second set of vertices representing operations in said processor;
- said edges representing valid connections between operations and said storage elements, and
- said connections modelling the data flow in said processor,
- linking said graph to tools and libraries required for said simulation, and
- executing said simulation whereby the required information about said processor is extracted from said graph.

19. The method as defined in claim 18 further comprising the step of representing hardware conflicts in said processor as access conflicts on said vertices representing storage elements.

20. The method as defined in claim 18 wherein, said storage elements are static and transitory storage elements and wherein all hardware conflicts in said processor are represented as access conflicts on said vertices representing storage elements.

21. The method as defined in claim 18 wherein, each vertex of said second set of vertices representing operations is annotated with its enabling condition, said enabling condition representing values of the instruction register of said processor that enable the execution of the operation represented by said vertex.

22. The method as defined in claim 18 wherein data-types supported by a storage element are specified, said method further comprising the steps of:
- specifying different vertices representing one storage element;
- annotating each of said different vertices with a data type supported by said one storage element, and
- specifying an alias relationship between said different vertices representing said one storage element.

23. The method as defined in claim 18 adapted for representing record storage elements, said method further comprising the steps of:
- specifying a vertex representing the concatenation of several storage elements;
- annotating said vertex with a data type being a record of the data types of said storage elements;
- specifying a structural relationship between said vertex and the vertices representing said storage elements.

24. The method as defined in claim 18 adapted for representing operations of which the execution depends on a defined condition, said method further comprising the steps of:
- specifying a subset of said second set of vertices representing operations, characterized in that all vertices in said subset depend on said condition;
- specifying in said subset a vertex that is connected by an incoming edge to a vertex of said first set of vertices that represents the storage element where said condition is available;
- specifying that said operations represented in said subset can only be enabled when said condition has a specific value.

25. The method as defined in claim 18 wherein, the execution times of operations are modelled, said method further comprising the steps of:
- annotating an enabling condition of said operation with the relative time step of the corresponding instruction issue with respect to the start of said operation;
- annotating said operation with the time steps relative to the start of said operation at which said operation accesses the input and output storage elements of said operation.

26. The method as defined in claim 18 wherein, said method represents a functional unit in said processor, said method further comprising the step of specifying a subset of said second set of vertices representing operations characterized in that all vertices in said subset execute on one functional unit.

27. The method as defined in claim 18 wherein said processor includes a controller unit, and operations modelling said controller unit are represented as vertices of said second set of vertices representing operations.

28. A retargetable simulator that performs the simulation of the execution of code on a programmable processor being embedded in an electronic system comprising:
- an electronic system with an embedded programmable processor,
- first tools to build a directed bipartite graph which internally represents said programmable processor with first and second sets of vertices and with edges, said graph comprising essentially all information about the instruction set and the hardware of said processor, said first set of vertices representing storage elements in said processor, and said second set of vertices representing operations in said processor;
- second tools and libraries required for simulating said processor, and
- means to link said graph to said second tools and libraries whereby the information about said processor required during simulation is extracted from said graph.

29. A method of synthesizing a programmable processor comprising the steps of:
- representing said processor as a directed bipartite graph with first and second sets of vertices and with edges, said graph comprising essentially all information about the instruction set and the hardware of said processor;
- said first set of vertices representing storage elements in said processor;
- said second set of vertices representing operations in said processor;
- linking said graph to tools and libraries required for generating a netlist of hardware building blocks;
- implementing said processor as a hardware device according to said netlist.
